# EUROPEAN PATENT APPLICATION

(11) **EP 2 947 686 A1**
(43) Date of publication of application: **25.11.2015**
(21) Application number: 14168792.1
(22) Date of filing: 19.05.2014
(51) Int. Cl.: H01L 21/677

(54) **Wafer processing method**

(71) Applicant: Meyer Burger AG, 3645 GWATT (Thun) (CH)
(72) Inventor: Indermühle, Marc, 3633 Amsoldigen (CH); Häsler, Michael, 3604 Thun (CH); Marti, Gerhard, 3012 Bern (CH)
(74) Representative: Patentbüro Paul Rosenich AG

(57) **Abstract**

The invention relates to a wafer aligning system (1), comprising a transporting means (3) for transporting a wafer (2) in a transporting direction (4), the transporting means (3) defining a transporting plane (5), characterized in that the wafer aligning system (1) comprises a delimiting means (6) limiting within the transporting plane (5) a movement of the wafer (2) perpendicular to the transport direction (4), wherein the delimiting means (6) defines an alignment line (7) extending essentially parallel to the transporting direction (4) of the transporting means (3), and a fluid flow generating means (9) for generating a fluid flow (10) forcing the wafer (2) against the delimiting means (6).

## Description

The invention refers to a wafer aligning system, comprising a transporting means for transporting a wafer in a transporting direction, the transporting means defining a transporting plane. The invention also refers to a method for aligning wafers and a wafer separating station.

Wafers for use in solar cell, semiconductor, optical devices and LED manufacturing, particularly in solar and electronic industry, are usually made of brittle materials such as silicon, quartz, sapphire boron, etc. These wafers are typically at least 30 µm thick, for particular applications even more than 60 µm thick, such as silicon wafer for solar cells that are typically 80-120 µm thick or sapphire sheets that are at least 0,2 mm thick. Even though such wafers bend, they are brittle in the sense that too much bending will break them, not merely deform them.

Wafers (e.g. silicon wafers for use in solar cells or sapphire wafers for use in LED manufacturing) are cut from a block (also called brick or ingot) in a wire cutting device employing a metal wire and abrasives. Usually abrasive particles suspended in slurry, that are transported by a metal wire, are used. Nowadays, wafers are cut more and more using fixed abrasives, which are directly attached to the metal wire. Such wire is often referred to as diamond wire.

The ingot to be cut for solar cells may be poly-crystalline or mono-crystalline semiconductor material, e.g. silicon. Other materials such as sapphire may be cut as well. In the latter case, the ingot is generally referred to as core or boule. The ingot is the base material the wafers are cut from. In the case of a poly-crystalline material, usually a large ingot is casted and bricks are cut from that. In case of a mono-crystalline material normally a round ingot is made for example using the Czochralski process and cut into the typical mono-crystalline wafer shape (pseudo square). Cores are drilled out of boule of sapphire. Cores and boules are here also referred to as ingots.

After (e.g. silicon, quartz, boron or sapphire) wafers have been cut, at first they normally remain attached to a beam. The beam is a piece of material holding the ingot at a distance of the wire saw, so that the cutting wire, that bends under the cutting action, does not cut into any machine parts. After having been cut, the wafers must be separated from the beam. Once this has been done, the wafers form a pile or queue and need to be separated to be treated individually.

Especially thin silicon wafers, as thin as 100 or even 80 µm need to be treated very gentile. Small shocks or bending forces may lead to damage that renders the wafers worthless.

During further processing, particularly subsequent to the wafer separation, the wafers are irregularly oriented. It is important for some processing, testing and/or assembling steps that the wafers or their edges are all aligned with respect to one reference direction.

TW201237989A discloses a method for positioning a solar silicon wafer. A working station comprises first and second bearing limits. The wafer can be abutted against the limits by means of a spring actuated clipping mechanism abutting against the wafer from opposite sides. With such a wafer holder only one wafer can be centrally aligned. Due to the mechanical impact of the clipping mechanism the risk of damaging the wafer is very high. Also the wafers cannot be positioned in an online or continuous process.

WO2009095474A1 discloses a device for labelling thin workpieces. The workpieces are aligned by means of a positioning means comprising two parallel conveyor belts trapping the workpiece from opposite sides. The mechanical impact to the workpiece is high, since the belts driven with the same velocity clamp the workpiece in between them. Thus, the risk of damaging the workpiece is very high.

WO1994002395A1 discloses a transport apparatus (water track) for transporting articles having a planar bottom element with fluid orifices. Fluid delivered through the orifices provides a motive force for which transports the article.

It is also known, that cameras determine the position or orientation of the non-aligned wafers and a gripper picks the wafers accordingly (i.e. with known orientation) and feeds them to an assembling step.

Problems occurring in prior art relate to high mechanical stresses exerted to wafers during alignment causing not only local damage on the edges of the wafers but also cracks extending through the whole wafer and even breakage. Designs using cameras as mentioned above are very costly.

The object of the present invention is to overcome these problems and to provide a wafer aligning system, particularly for thin and brittle wafers which treats the wafers gentle, i.e. applying only very small and smooth alignment forces onto the wafers. In addition the wafers should be aligned rapidly and preferably during their transport, i.e. not stopping them during the alignment process. The wafer aligning system should be cost-effective and space saving. Integration of the wafer aligning system into processing station should be possible.

This object is achieved by a wafer aligning system as mentioned above, characterized in that the system comprises a delimiting means limiting within the transporting plane a movement of the wafer perpendicular to the transport direction, wherein the delimiting means defines an alignment line extending essentially parallel to the transporting direction of the transporting means, and a fluid flow generating means for generating a fluid flow forcing the wafer against the delimiting means.

The force exerted to the wafer is communicated via a fluid making the interaction with the wafer very gentle and smooth, such that mechanical stresses can be effectively avoided. The fluid may be a gas (e.g. air or compressed air, the latter containing less moisture) or a liquid (e.g. (purified) water, de-ionized water, a water-based liquid, a cutting liquid and/or a cleaning liquid). Different fluids may be used at different stages of the alignment process. For particular applications it may be advantageous if the wafers are kept wet during transport. A further advantage of the invention is that the alignment is performed during wafer transport. This allows a continuous movement of the wafers during the alignment process. Further advantages of the inventive system are: low capex, only few components are needed, preferably no electronic components are needed in the range where the wafers are aligned and precise alignment of wafers.

The wafer lie with one of its flat surfaces on the transport means (the transport plane is parallel to the wafers flat surface). By the impact of the fluid flow the wafer is moved within the transport plane (i.e. parallel to the transport plane), such that an edge of the wafer comes into abutment with the delimiting means. That wafer edge becomes in line with the alignment line defined by the delimiting means.

The fluid flow is directed towards the delimiting means or has at least one directional component, which is parallel to the transport plane and faces towards the delimiting means. The fluid flow may be e.g. in a form of a (more or less) focused jet or may be a diverging fluid flow, with a spraying angle defining the divergence. In both cases under the term 'fluid flow direction' the central fluid path of the fluid flow is understood. The fluid flow, especially a liquid flow, may be bent strongly under the influence of gravity. In that case under the term 'fluid flow direction' the central fluid path of the fluid as it leaves the means for generating a fluid flow is understood. The fluid flow may impinge directly on the wafers and (in time parallel)/or to the transport surface (such as belt, slide) laterally from the wafers. The fluid flow may be provided by individual, non-continuous flushes (fluid flow generation means is a flushing means), e.g. one flush for each wafer, or by a continuous fluid flow.

In order to limit a movement of the wafer perpendicular to the transport direction the delimiting means is formed by at least one limiting member projecting beyond the transporting plane. As will be described hereinafter the limiting member may be e.g. a conveyor belt, a roll, a stationary limiting surface or a limiting member integrated within the transport means. It would be also possible that the delimiting means also extends below the transporting plane.

The main advantage of the current invention over the state of the art is that the system is very cost-effective while still treating the wafers very gently. In addition the system can be adapted to different wafer sizes and materials. Moreover, the throughput of the system can be increased easily, provided the wafers allow this, by increasing the speed of the transporting means and the power of the fluid flow generating means. This can be done by adapting the software of a controller. In addition the location and direction of the fluid flow generating means may be altered, which is still easy to do.

The fluid flow from the flow generating means may be directed by shielding or flow controlling means that influence the direction of flow. In this way less fluid can escape and the fluid flow may be less powerful thus further reducing resources needed (pressurized air, means for generating a strong flow), while treating the wafers more gently. Also one fluid flow generating means may thus deliver fluid to many locations/wafers.

Preferably the spraying angle of the fluid flow generating means lies in the range of 30° to 60°, preferably from 40° to 50°.

Preferably the fluid flow generating means are located at a distance less than 60 mm, preferably less than 50 mm, away from the transporting plane of the transporting means, measured perpendicularly from the transporting direction. In this way the fluid flow engages a larger area of the wafer, thus preventing localized large forces and stresses.

Preferably the fluid flow generating means contain means selected from the group consisting of a nozzle, preferably for pressurized air, a propeller, a fan, a duct for under-pressure, a basin with an outlet or any combination thereof, preferably multiple instances of these means being provided respectively

(each element of this group may or may not be present and may be provided once or multiple times). If multiple means for generating a fluid flow are present, they may be controlled individually, for example by a controller or they may for example be pre-set as to deliver different flows of fluid to the wafer. The means for generating a fluid flow may thus provide a more or less uniform pressure over larger regions of the wafer, thus minimizing the local tension in the wafer. Moreover, number and type of fluid flow generating means may be chosen and controlled to optimize the alignment process.

Preferably a controller is provided for controlling any element selected form the group consisting of the transporting means, the delimiting means and the fluid flow generating means or any combination thereof. In this way the means for generating a fluid flow may be turned on and off at appropriate times, for example when a wafer arrives. Also the transporting means may be turned on just before wafers arrive or their speeds may be adjusted (dynamically) to the wafers. Sensors maybe used for detecting the presence, rough orientation and type of wafers.

Preferably the speed of the fluid flow generated by the fluid flow generating means is a function of the speed of the transporting means, the speed of the fluid flow preferably being larger than the speed of the transporting means. For wafers, the speed of the transporting means may lie between 0.1 and 1 m/s, preferably between 0.1 and 0.5 m/s, more preferred between 0.1 and 0.25 m/s.

The fluid of the fluid flow generating means may have an average speed between 0.1 and 300 m/s, preferably between 5 and 50 m/s and even more preferably between 20 and 40 m/s. The speed of the fluid flow being defined as the speed of the fluid as it leaves the means for generating a fluid flow.

Preferably, the fluid flow generating means is arranged with respect to the delimiting means on the opposing side of the transporting means, e.g. a conveyor belt, water track or a slide path. The fluid flow crosses the transport path in a transverse direction. Both, the transporting means and the delimiting means when comprising a conveyer belt, may respectively comprise a static supporting structure (i.e. a support which is stationary with respect to the moving belt)under the belt forming the transport surface or the limiting surface, so that the belt is supported and builds a more steady plane.

A preferred embodiment is thus characterized in, that the delimiting means has a stationary support extending parallel to the limiting surface. The stationary support is arranged behind that belt portion forming the limiting surface. A more precise alignment may be achieved with such a stationary support preventing the belt from bending due to the force exerted by the wafers.

Similarly, also the transporting means may have such a stationary support extending parallel to the transporting surface.

The invention particularly refers to systems for aligning wafers made of brittle materials, such as silicon, quartz, sapphire boron, etc., particularly semiconductor material.

Particularly, the invention is concerned with the alignment of wafers for solar cells after they have been separated. After the wafers have been removed from the beam, their orientation is not very precise. Removing one wafer after the other from a wafer block accommodated in a carrier introduces additional miss-alignment. After separation the wafers should be aligned so that they can be picked up and placed in a holder for being further processed into solar cells, e.g. by texturization, doping, etc..

The invention is particularly suited for square and pseudo-square wafers.

Preferably, the delimiting means defines a limiting surface which is inclined relative to the transporting plane of the transporting means, wherein preferably the limiting surface encloses with the transporting plane an angle between 70° and 110°, more preferred by an angle of essentially 90°. The limiting surface forms a stop for the lateral movement of the wafers. Preferably, the delimiting means is formed by a conveyor belt. The belt plane facing towards the transport path (and thus towards the wafers) is the limiting surface, which defines the alignment line. The belt plane is the plane coinciding with the surface of the belt touching the wafers. The belt may be synchronized with the transport means. The wafer edge may experience the same 'velocity' as the wafer's flat surface lying against the transporting means.

A possible embodiment would comprise two conveyor belts: a first conveyer belt, which is the transporting means, and a second conveyer belt, which is the delimiting means. Preferably, the first conveyor belt is essentially horizontal and the second conveyor belt is essentially vertical.

Preferably the fluid flow only exerts a force on a wafer when the latter is over one complete edge supported by the delimiting means. Moreover, if a force is applied when a wafer is only partially supported, it would start rotating.

Preferably, the transporting means is formed by rolls rotatable around their axes, wherein preferably the rolls are connected to a rotary drive. Here, the transport surface is formed by that points of the roll's cylinder surfaces, which face - at a certain time - towards the flat surface of the wafers.

Preferably, the delimiting means is formed by rolls rotatable around their axes, wherein preferably the rolls are connected to a rotary drive. The axes of the rolls may be oriented essentially perpendicular to the transport direction. Here, the limiting surface is formed by that points of the roll's cylinder surfaces, which face - at a certain time - towards the transporting path (and thus towards the wafers, i.e. towards an edge of a wafer). With other words: that points lie within the alignment line of the delimiting means. An advantage of this embodiment is that the rolls can rotate more readily because of the low friction and little inertia and therefore do not need driving means. The wafer and/or the fluid may make the rolls rotate. Means may be provided on the rolls to transform the energy of the fluid flow into rotational energy like a watermill. Also the fluid may move more freely over the transporting means, thus preventing fluid from collecting near the delimiting means. In addition, rolls make it possible that the transporting means and/or delimiting means (when respectively comprising rolls) respectively have velocities that vary over the transport path. In this way the wafers can be sped up and slowed down.

Preferably, the delimiting means comprises at least one moveable part exerting a moving action on the wafer and wherein the transporting means and the delimiting means are adapted such, that the transporting velocity of the transporting means and the velocity of the movable part of the delimiting means at a point of the alignment line are essentially the same. This allows a smooth movement of the wafers in transport direction without friction and without the risk of de-aligning again.

Preferably, the delimiting means is an integral part of the transporting means, wherein preferably the delimiting means is formed by at least one limiting member projecting beyond the transporting plane. A preferred embodiment would be a conveyor belt as transporting means and one or multiple members that/which is/are part of or fixed to the belt of the conveyor. This allows a very space saving solution, since no separate delimiting means arranged laterally of the transport means are needed

Preferably, the delimiting means defines a limiting surface which is stationary with respect to the moving parts of the transporting means. This is a very cost effective solution, since the delimiting means does not need moveable parts.

Preferably, the delimiting means defines a smooth limiting surface, preferably made from nylon or rubber. Friction in transport direction is effectively reduced.

Preferably, the transporting means is a conveyor belt, the belt plane defining the transport plane. This allows a very reliable and controllable transport of the wafers.

Preferably, the transporting means is a slide path, with the transporting direction being preferably inclined with respect to the horizontal. Slide path may be operated only by gravitational force or by means of a fluid drive comprising orifices in the bottom of the slide path for creating a fluid film between slide path and wafers. Preferably, the transporting means is a fluid track, preferably a water track. Here, the wafers may be propelled by fluid beams as well.

Preferably, the transporting plane is inclined with respect to the horizontal, thereby defining a decline towards the delimiting means. Here, gravitational force assists the fluid flow for moving the wafers against the delimiting means.

Preferably, the transporting plane is defined by a plurality of protrusions for locally supporting the wafer. The wafers thus experience less friction and thus may be flushed to the side and be aligned more easily. The transporting means preferably comprising the protrusions. I.e. the protrusions may be on the conveyor belt, wafer track, glide path, etc..

Preferably, the fluid flow generating means defines a fluid flow direction, which is transverse, preferably essentially perpendicular to the transporting direction. The wafers are reliably moved and/or rotated towards the delimiting means, such that an edge of the wafer comes into line with the alignment line.

Preferably, the fluid flow direction defined by the fluid flow generating means has a directional component pointing in the same direction as the transporting direction, wherein preferably the angle (β) between the fluid flow direction and a plane which is perpendicular to the transporting direction is smaller than 30°. In this embodiment the fluid flow supports the movement of the wafer in the transporting direction and the wafers are not only propelled by the transporting and/or delimiting means.

Preferably, the fluid flow direction defined by the fluid flow generating means encloses an angle α, preferably between 0° and 45°, more preferred between 20° and 40°, with the transporting plane. A particularly preferred angle amounts to approximately 30°. The force transmission communicated by the fluid flow may be distributed over the top flat surface of the wafer more uniformly, if the fluid flow direction is not (only) parallel to the transport plane. The force transmission is more effective, such that the fluid flow can be minimized.

Preferably, the velocity of the fluid flow when leaving the fluid flow generating means is between 20m/s and 45m/s, preferably approximately 38m/s.

Preferably, the fluid flow generating means comprises at least one nozzle arranged along the transporting means, preferably an arrangement of nozzles. The nozzles of the fluid flow generating may be directed towards the transport path or towards the delimiting means by the angles of the preceding embodiments. It is possible that the nozzles of the arrangement are differently orientated defining different fluid flow directions. This allows to reliably align also differently orientated wafers.

Preferably, at least one fluid passage is formed in the delimiting means and/or in the transport means and/or between the transporting means and the delimiting means for collecting and preferably re-using the fluid originating from the fluid flow generating means. Fluid consumption can be minimized.

The object of the invention is also achieved by a method for aligning wafers with a wafer aligning system, particularly according to one of the preceding embodiments, comprising a step of transporting at least one wafer in a transporting direction within a transporting plane, wherein within the transporting plane a movement of the wafer perpendicular to the transporting direction is limited by a delimiting means, wherein the delimiting means defines an alignment line extending essentially parallel to the transporting direction of the transporting means, and a step of generating a fluid flow forcing the wafer against the delimiting means.

The object of the invention is also achieved by wafer separating station for separating wafers from a wafer block, wherein the wafer separation station comprises a wafer aligning system according to the invention.

Further embodiments of the invention are indicated in the figures and in the dependent claims. The list of reference marks forms part of the disclosure. The invention will now be explained in detail by the drawings. In the drawings:
Fig. 1 shows in a top view a wafer alignment system according to the invention;
Fig. 2 shows in a side view a wafer alignment system;
Fig. 3 to 6 show embodiments of the wafer alignment system;
Fig. 7 shows an embodiment with delimiting means formed by rolls;
Fig. 8 show an embodiment with the delimiting means being integrated in the transport means;
Fig. 9 shows an embodiment with a slide path;
Fig. 10 shows a wafer separating station.

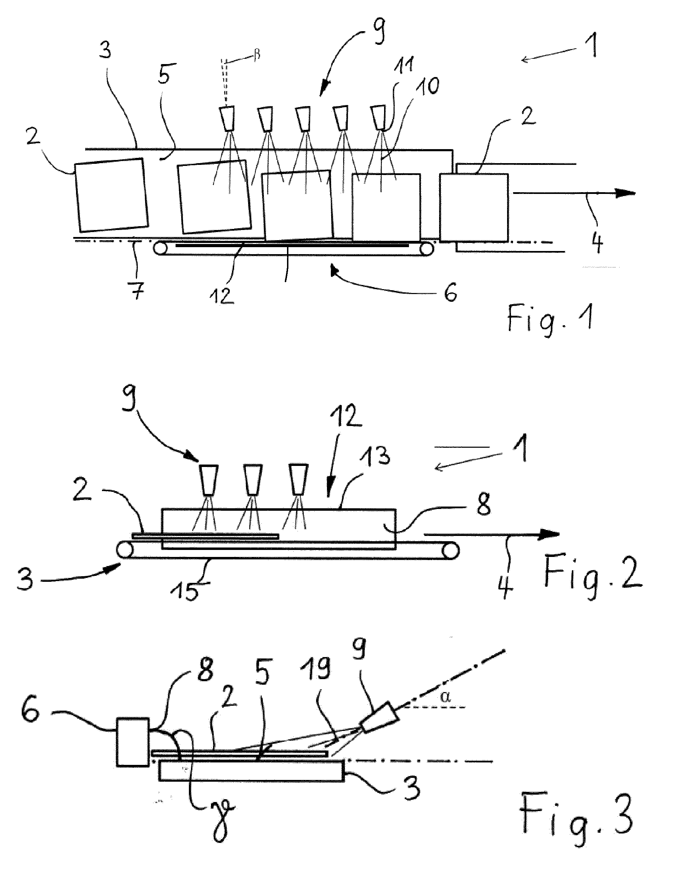

Fig. 1 shows - from a top view - a wafer aligning system 1 comprising a transporting means 3 for transporting wafers 2 in a transporting direction 4.
The transporting means 3 defining a transporting plane 5. The wafers 2 extend parallel to the transport plane 5 during transport.

The wafer aligning system 1 comprises a delimiting means 6 limiting within the transporting plane 5 a movement of a wafer 2 perpendicular to the transport direction 4. The delimiting means 6 defines an alignment line 7 extending essentially parallel to the transporting direction 4 of the transporting means 3.

The wafer aligning system 1 comprises a fluid flow generating means 9 for generating a fluid flow 10 forcing the wafer 2 against the delimiting means 6.

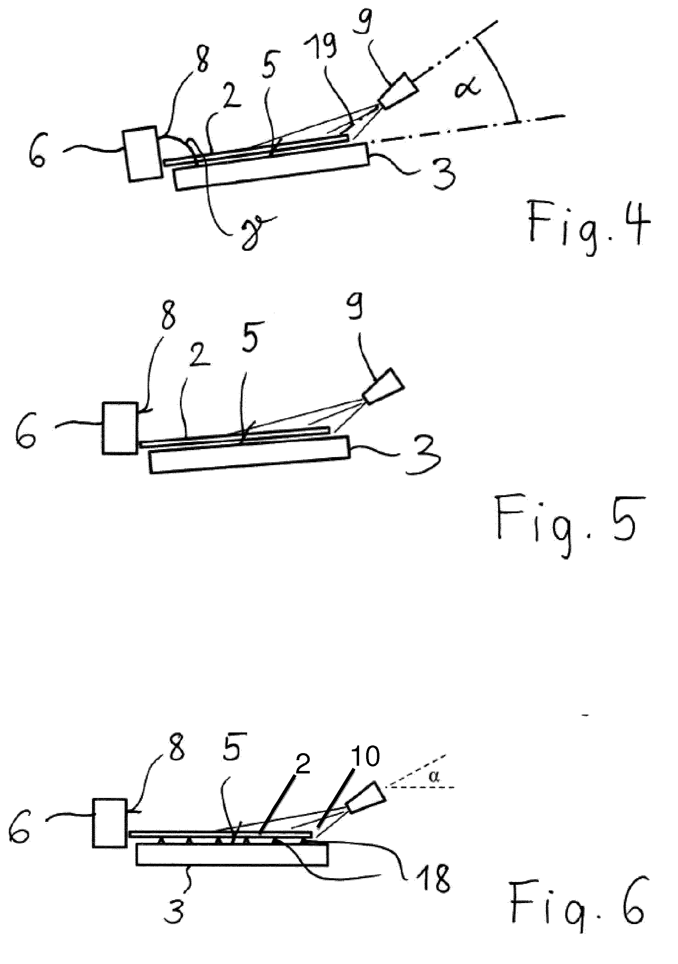

As can be seen from the side view of Fig. 2, the delimiting means 6 defines a limiting surface 8 which is inclined relative to the transporting plane 5 of the transporting means 3. Preferably, the limiting surface 8 encloses with the transporting plane 5 an angle γ between 70° and 110° (Fig. 5), more preferred by an angle γ of essentially 90° (Fig. 3, 4 and 6).

In the embodiment shown in Fig. 1 and 2, the delimiting means 6 is formed by a conveyor belt 12, wherein the belt 13 forms the limiting surface 8 being inclined with respect to the transport plane 5.

Preferably, the delimiting means 6 has a stationary support 24 extending parallel to the limiting surface 8. The stationary support 24 is arranged behind that belt portion forming the limiting surface 8. A more precise alignment may be achieved with such a stationary support 24 preventing the belt 13 from bending due to the force exerted by the wafers 2.

Similarly, also the transporting means 3 may have such a stationary support (not shown) extending parallel to the transporting surface.

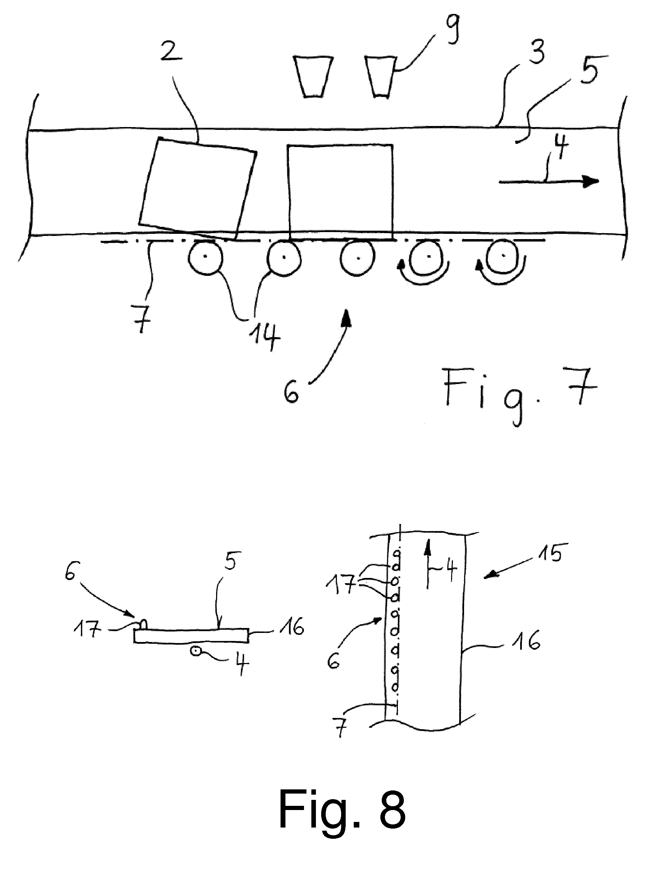

In the embodiment of Fig. 7 the delimiting means 6 is formed by rolls 14 rotatable around their axes. The axis of the rolls 14 are essentially perpendicular to the transport direction 4. Points on the cylindrical surface of the rolls 14 define the alignment line 7. The rolls 14 are preferably connected to a rotary drive, wherein the rotary movement of the rolls 14 may by synchronized with respect to the velocity of the wafers 2 along the transport direction 4.

In these embodiments the delimiting means 6 comprises at least one moveable part 13, 14, exerting a moving action to the wafer 2. Preferably, the transporting means 3 and the delimiting means 6 are adapted such, that the transporting velocity of the transporting means 3 and the velocity of the movable part 13, 15 of the delimiting means 6 at a point on the alignment line 7 are essentially the same. With other words: transport means 3 and delimiting means 6 are synchronized.

Alternatively the delimiting means 6 may be an integral part of the transporting means 3 (Fig. 8). The delimiting means 6 is formed by at least one limiting member projecting 17 beyond the transporting plane 5. Here multiple limiting members 17 are arranged on the belt 16 of the conveyor belt 15 which is the transporting means 3. The limiting members 17 move with the wafers 2; no friction can occur.

It would also be possible, that the delimiting means 6 defines a limiting surface 8 which is stationary with respect to the transporting means 3. It is preferred that the delimiting means 6 defines a smooth limiting surface 8, preferably made from nylon or rubber.

As already mentioned the transporting means 3 may be a conveyor belt 15, wherein the belt 16 defines the transport plane 5.

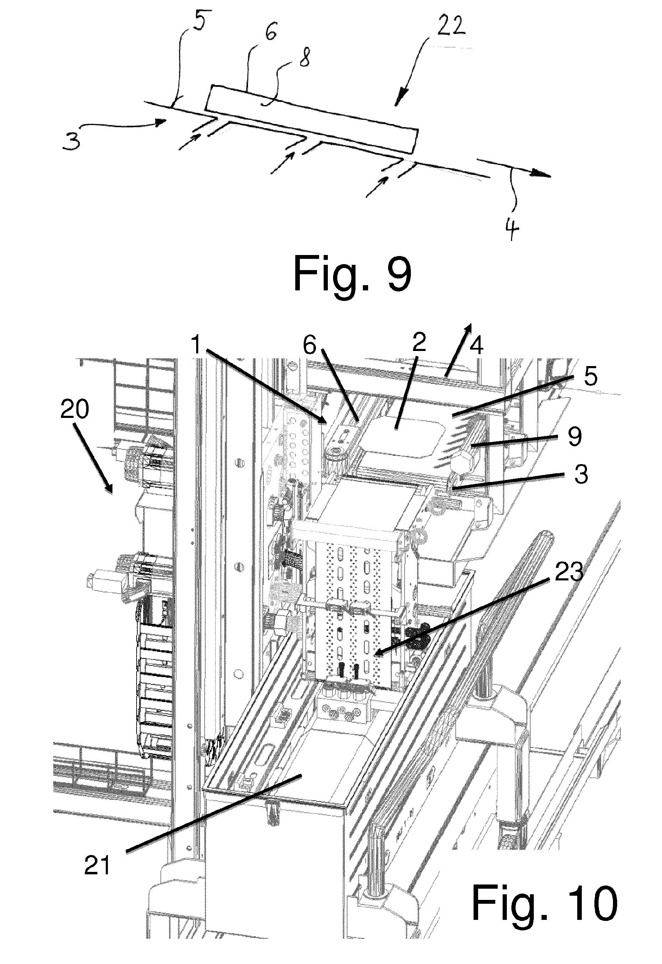

Fig. 9 shows - in a partial cut - an embodiment with the transporting means 3 being a slide path 22. The transporting direction 4 may be inclined with respect to the horizontal. Alternatively or additionally fluid orifices may be provided in the bottom slide surface for forming a fluid film below the wafers 2. The transporting means 3 may be any kind of fluid track, preferably water track.

Fig. 4 and 5 show embodiments with the transporting plane 5 being inclined with respect to the horizontal, thereby defining a decline towards the delimiting means 6.

Fig. 6 shows an embodiment, wherein the transporting plane 5 is defined by a plurality of protrusions 18 for locally supporting the wafer 2. The fluid flow 10 now may flow over and underneath wafer 2.

The fluid flow generating means 9 defines a fluid flow direction 19, which is transverse, preferably essentially perpendicular to the transporting direction 4. In the case of a diverging fluid flow the fluid flow direction may be defined by the central fluid path of the diverging fluid flow. In such a sense the angle specifications in this document have to be understood.

In the embodiment of Fig. 1 the nozzles of the fluid flow generating means 9 is slightly tilted by an angle β, such that the fluid flow direction 19 defined by the fluid flow generating means 9 has a directional component pointing in the same direction as the transporting direction 4. Preferably the angle β between the fluid flow direction 19 and a (virtual) plane which is perpendicular to the transporting direction 4 is smaller than 30°.

In the embodiments of Figs. 3 to 6 the fluid flow direction 19 defined by the fluid flow generating means 9 is inclined with respect to the transporting plane 5. The angle α enclosed by the fluid flow direction 19 and the transporting plane 5 is preferably larger than 0° and 'smaller than 45°.

As can be seen from Fig. 1 and 2 the fluid flow generating means 9 may comprise nozzles 11 arranged along the transport direction 4.

At least one fluid passage may be formed in the delimiting means 6 and/or in the transporting means 3 and/or between the transporting means 3 and the delimiting means 6 (see e.g. gap between conveyor belt 12 and delimiting means 6 in Fig. 1) for collecting and preferably re-using the fluid originating from the fluid flow generating means 9.

A corresponding method for aligning wafers with a wafer aligning system, particularly according to one of the described embodiments, comprises: a step of transporting at least one wafer 2 in a transporting direction 4 within a transporting plane 5, wherein within the transporting plane 5 a movement of the wafer 2 perpendicular to the transporting direction 3 is limited by a delimiting means 6, wherein the delimiting means 6 defines an alignment line 7 extending essentially parallel to the transporting direction 4 of the transporting means 3, and a step of generating a fluid flow 10 forcing the wafer 2 against the delimiting means 6.

Finally, Fig. 10 shows a separating station 20 for separating individual wafers 2 from a wafer block 21 (i.e. from an arrangement of the wafers subsequent to cutting them in a wire web of a wire saw). The wafer separation station 20 comprises an inventive wafer aligning system 1, which may be design according to one of the embodiments described above.

The term "wafer block" is used if the wafers are still essentially in the same relative position or order to each other as they were immediately after finishing the cutting process, the wafer arrangement is also called a wafer block (or wafer brick); it is a stack- or queue-like arrangement.

The wafer separating station usually comprises a essentially vertical transporting means 23 (e.g. conveyor belt) picking individual wafers 2 subsequent to each other from the wafer block arrangement. The wafer block 21 may be accommodated in a container.

The mainly vertical transporting means 23 transfers the wafers to a transporting means 3 which is part of the wafer aligning system 1. The wafers may be aligned immediately after separating them from the wafer block.

The invention is not restricted to these embodiments. Other variants will be obvious for the person skilled in the art and are considered to lie within the scope of the invention as formulated in the following claims. Individual features described in above specification, particularly with respect to the figures may be combined with each other to form other embodiments and/or applied mutatis mutandis to what is described in the claims and to the rest of the description.

### List of reference marks

- 1: wafer aligning system
- 2: wafer
- 3: transporting means
- 4: transporting direction
- 5: transporting plane
- 6: delimiting means
- 7: alignment line
- 8: limiting surface
- 9: fluid flow generating means
- 10: fluid flow
- 11: nozzle
- 12: conveyor belt
- 13: belt of conveyor belt 12
- 14: roll
- 15: conveyor belt
- 16: belt of conveyor belt 15
- 17: limiting member
- 18: protrusions
- 19: fluid flow direction
- 20: wafer separating station
- 21: wafer block
- 22: Slide path
- 23: transporting means
- 24: stationary support

## Claims

1. Wafer aligning system (1), comprising a transporting means (3) for transporting a wafer (2) in a transporting direction (4), the transporting means (3) defining a transporting plane (5), **characterized in that** the wafer aligning system (1) comprises a delimiting means (6) limiting within the transporting plane (5) a movement of the wafer (2) perpendicular to the transporting direction (4), wherein the delimiting means (6) defines an alignment line (7) extending essentially parallel to the transporting direction (4) of the transporting means (3), and a fluid flow generating means (9) for generating a fluid flow (10) forcing the wafer (2) against the delimiting means (6).

2. Wafer aligning system according to claim 1, wherein the delimiting means (6) defines a limiting surface (8) which is inclined relative to the transporting plane (5) of the transporting means (3), wherein preferably the limiting surface (8) encloses with the transporting plane (5) an angle (γ) between 70° and 110°, more preferred by an angle (γ) of essentially 90°.

3. Wafer aligning system according to claim 1 or 2, wherein the delimiting means (6) is formed by a conveyor belt (12).

4. Wafer aligning system according to claim 1 or 2, wherein the delimiting means (6) is formed by rolls (14) rotatable around their axes, wherein preferably the rolls are connected to a rotary drive.

5. Wafer aligning system according to one of the preceding claims,
wherein the delimiting means (6) comprises at least one moveable part (12, 13, 14) exerting a moving action on the wafer (2) and wherein the transporting means (3) and the delimiting means (6) are adapted such, that the transporting velocity of the transporting means (3) and the velocity of the movable part (13, 15) of the delimiting means (6) at a point on the alignment line (7) are essentially the same.

6. Wafer aligning system according to claim 1 or 2, wherein the delimiting means (6) is an integral part of the transporting means (3), wherein preferably the delimiting means (6) is formed by at least one limiting member projecting (17) beyond the transporting plane (5).

7. Wafer aligning system according to claim 1 or 2, wherein the delimiting means (6) defines a limiting surface (8) which is stationary with respect to moving parts of the transporting means (3).

8. Wafer aligning system according to one of the preceding claims,
wherein the delimiting means (6) defines a smooth limiting surface (8), preferably made from nylon or rubber.

9. Wafer aligning system according to one of the preceding claims,
wherein the transporting means (3) is a conveyor belt (15), the belt plane defining the transport plane (5).

10. Wafer aligning system according to one of the preceding claims,
wherein the transporting means (3) is a slide path (22), with the transporting direction (4) being preferably inclined with respect to the horizontal, and/or wherein the transporting means (3) comprises a fluid track, preferably a water track.

11. Wafer aligning system according to one of the preceding claims,
wherein the transporting means (3) and/or the delimiting means (6) comprise(s) rolls (14) rotatable around their axes, wherein preferably at least one of the rolls (14) is connected to a rotary drive.

12. Wafer aligning system according to one of the preceding claims,
wherein the fluid flow generating means (9) defines a fluid flow direction (19), which is transverse, preferably essentially perpendicular to the transporting direction (4).

13. Wafer aligning system according to one of the preceding claims,
wherein at least one fluid passage is formed in the delimiting means (6) and/or in the transporting means (3) and/or between the transporting means (3) and the delimiting means (6) for collecting and preferably re-using the fluid originating from the fluid flow generating means (9).

14. Method for aligning wafers with a wafer aligning system, particularly according to one of the preceding claims, comprising a step of transporting at least one wafer (2) in a transporting direction (4) within a transporting plane (5), wherein within the transporting plane (5) a movement of the wafer (2) perpendicular to the transporting direction (3) is limited by a delimiting means (6), wherein the delimiting means (6) defines an alignment line (7) extending essentially parallel to the transporting direction (4) of the transporting means (3), and a step of generating a fluid flow (10) forcing the wafer (2) against the delimiting means (6).

15. Wafer separating station (20) for separating wafers (2) from a wafer block (21), wherein the wafer separation station (20) comprises a wafer aligning system (1) according to one of the claims 1 to 13.
